# EUROPÄISCHE PATENTSCHRIFT

(11) **EP 2 878 584 B1**
(45) Veröffentlichungstag und Bekanntmachung des Hinweises auf die Patenterteilung: **04.01.2017**
(21) Anmeldenummer: 13194963.8
(22) Anmeldetag: 28.11.2013
(51) Int. Cl.: C03C 3/06, C03C 17/04

(54) **Verfahren zur Herstellung eines beschichteten Bauteils aus Quarzglas oder Quarzgut**
Method for producing a coated component of quartz glass or fused silica
Procédé de fabrication d'un composant revêtu avec verre de quartz ou silice fondue

(43) Veröffentlichungstag der Anmeldung: 03.06.2015
(73) Patentinhaber: Heraeus Quarzglas GmbH & Co. KG, 63450 Hanau (DE)
(72) Erfinder: SCHENK, Christian, 55218 Ingelheim (DE); SCHEICH, Gerrit, 63500 Seiligenstadt (DE); NIELSEN, Nils-Christian, 65388 Schlangenbad (DE)
(74) Vertreter: Staudt, Armin Walter

(56) Entgegenhaltungen:
- WO-A2-2011/042262
- DE-A1-102006 032 687
- OLHERO S M ET AL: "Particle segregation phenomena occurring during the slip casting process", CERAMICS INTERNATIONAL, ELSEVIER, AMSTERDAM, NL, Bd. 28, Nr. 4, 1. Januar 2002 (2002-01-01) , Seiten 377-386, XP004349695, ISSN: 0272-8842, DOI: 10.1016/S0272-8842(01)00105-5

## Beschreibung

### Technisches Gebiet

Die Erfindung betrifft ein Verfahren zur Herstellung eines beschichteten Bauteils aus Quarzglas oder aus Quarzgut, umfassend folgende Verfahrensschritte:
(a) Bereitstellen eines Substrats aus Quarzglas oder aus Quarzgut, das eine Beschichtungsfläche aufweist,
(b) Aufbringen einer SiO₂-Körnungsschicht auf der Beschichtungsfläche, welche einen an die Beschichtungsfläche angrenzenden Innenbereich mit einem ersten Körnungs-Feinanteil und einen an die freie Oberfläche der Körnungsschicht angrenzenden Außenbereich mit einem zweiten Körnungs-Feinanteil aufweist, wobei der zweite Körnungs-Feinanteil höher ist als der erste Körnungs-Feinanteil,
(c) Sintern der Körnungsschicht unter Ausbildung einer SiO₂-Oberflächenschicht.

Bauteile aus undotiertem oder dotiertem Quarzglas oder aus Quarzgut werden für eine Vielzahl von Anwendungen eingesetzt, bei denen es auf hohe chemische und thermische Beständigkeit oder optische Durchlässigkeit ankommt. Im Folgenden wird der Begriff "Quarzglas" als Sammelbegriff auch für Quarzgut verwendet. Als Beispiele seien genannt: Hüllrohre, Kolben, Abdeckplatten, Spiegelsubstrate für die Optik, Reaktoren, Apparaturen oder Tiegel aus Quarzglas in der chemischen Verfahrenstechnik und im Apparatebau, Trägerhorden, Glocken, Tiegel oder Schutzschilde in der Halbleiterfertigung.

Zur Optimierung der mechanischen, optischen oder chemischen Oberflächeneigenschaften kann ein vorab erzeugtes Quarzglas-Bauteil ganz oder teilweise mit einer an den spezifischen Verwendungszweck angepassten Funktionsschicht versehen werden. Bekannte Oberflächenmodifikationen umfassen die Beschichtung mit einem Werkstoff mit höherer Erweichungstemperatur zur Verbesserung der Temperaturstabilität oder der chemischen Beständigkeit oder die Beschichtung mit hochreinem Material zur Verringerung der vom Bauteil ausgehenden Kontaminationsgefahr.

### Stand der Technik

Bei Anwendungen, bei denen das Quarzglas-Bauteil hohen thermischen Belastungen und chemisch aggressiven Umgebungen ausgesetzt ist, kommt es häufig auch auf eine glatte und fehlerfreie Oberfläche an. Denn dichte, blasenarme Oberflächenschichten verbessern die Ätz- und Korrosionsbeständigkeit.

So unterliegt beispielsweise die Wandung von Tiegeln aus Quarzgut für die Herstellung von Silicium oder die Innenwandung eines opaken Quarzglastiegels, wie er zum Ziehen von Einkristallen nach dem sogenannten Czochralski-Verfahren eingesetzt wird, im Kontakt mit der Siliziumschmelze hohen mechanischen, chemischen und thermischen Belastungen. Um den korrosiven Angriff der Siliziumschmelze zu verringern und die damit einhergehende Freisetzung von Verunreinigungen aus der Tiegelwandung zu minimieren, wird daher auf der ansonsten opaken Wandung eine Innenschicht aus dichtem und transparentem Quarzglas erzeugt.

Im einfachsten Fall wird die Oberfläche durch "Feuerpolieren" geglättet und verdichtet. Dabei wird die poröse Wandung mittels Plasma- oder Knallgasflamme lokal auf hohe Temperaturen im Bereich von 1650 °C bis 2200 °C erhitzt, so dass sich das opake, poröse Grundmaterial in einem oberflächennahen Bereich in transparentes Quarzglas umwandelt. Es hat sich jedoch gezeigt, dass dadurch nur sehr dünne transparente Schichten erreichbar sind. Denn die verglaste, transparente Oberflächenschicht wirkt als Wärmeisolator, der ein ausreichendes Erhitzen der darunter liegenden, noch opaken Bereiche erschwert. Die Bearbeitung mit höherer Flammentemperatur führt leicht zu einer plastischen Verformung und zum Abdampfen von gasförmigem Siliciummonoxid (SiO).

Das Dichtsintern kann erleichtert werden, indem die thermisch zu verdichtenden oberflächennahen Bauteil-Bereiche mit einer niedrigeren Viskosität oder einer höherer Sinteraktivität ausgestattet werden. Diesen Vorschlag macht beispielsweise die DE 10 2008 030 310 A1, aus der auch ein Verfahren der eingangs genannten Gattung bekannt ist. Dabei wird ein Quarzglastiegel aus mehreren Schichten aus SiO₂-Körnung aufgebaut, deren mittlere Teilchengröße sukzessive abnimmt. Auf eine tiegelförmige Körnungsschicht aus mechanisch verfestigtem grobkörnigem Quarzsand wird zunächst eine Schicht aus synthetisch hergestellter Quarzglaskörnung mit einer Teilchengröße im Bereich von 50 bis 120 µm, und darauf wiederum eine innerste SiO₂-Körnungsschicht aus sphärischen, synthetisch erzeugten, feinen SiO₂-Teilchen mit einer mittleren Teilchengröße um 15 µm ausgeformt. Die Körnungsschichten werden anschließend von innen nach außen mittels eines Lichtbogens gesintert, wobei das feinteilige Quarzglaspulver der innersten Körnungsschicht zuerst aufschmilzt und dabei eine dichte Glasschicht bildet. Deren hohe Sinteraktivität führt dazu, dass bei vergleichsweise niedriger Temperatur und kurzer Heizdauer eine ausreichend dicke und besonders gleichmäßige glasige Innenschicht ohne lokale Inhomogenitäten und Blasen erhalten werden kann.

Die Herstellung der transparenten Innenschicht ist jedoch aufwändig, denn sie erfordert eine Vielzahl von Beschichtungsschritten mit unterschiedlicher SiO₂-Körnung, die sich in ihren Eigenschaften und Schichtbildungscharakteristiken unterscheiden. So beruht beispielsweise die hohe Sinteraktivität der synthetischen SiO₂-Körnung der innersten Schicht auf ihrer Feinteiligkeit und hohen spezifischen BET-Oberfläche. Diese Eigenschaften erschweren aber andererseits die Handhabung bei üblichen Prozessbedingungen. So kommt es beispielsweise leicht zu einem Verblasen der feinteiligen Körnung unter dem Einfluss des Lichtbogendrucks und durch Gasströme und thermische Konvektion, was die Herstellung einer Körnungsschicht mit gleichmäßiger Dicke erschwert.

Diesen Nachteil vermeidet an und für sich die Herstellung der Schichten mittels üblicher Schlickergießverfahren, bei denen das feinteilige SiO₂-Pulver in einer Dispersionsflüssigkeit aufgenommen und dadurch einfacher handhabbar wird.

So beschreibt die DE 2004 051 846 A1 die Herstellung eines mit einer Reflektorschicht versehenen Quarzglasbauteils, wobei die Reflektorschicht ebenfalls aus Quarzglas besteht und mittels eines Schlickergießverfahrens hergestellt wird. Dabei wird ein hochgefüllter, gießfähiger, wässriger Schlicker erzeugt, der amorphe SiO₂-Teilchen enthält. Die amorphen SiO₂-Teilchen werden durch Nassmahlen von SiO₂-Körnung hergestellt und weisen eine mittlere Teilchengröße im Bereich von 1 bis 50 µm auf. Auf der zu beschichtenden Oberfläche eines Quarzglas-Basiskörpers wird eine Schicht des Schlickers durch Sprühen, elektrostatisch unterstütztes Sprühen, Fluten, Schleudern, Tauchen oder Aufstreichen aufgetragen. Die Schlickerschicht wird zu einer Grünschicht getrocknet und anschließend zu der Reflektorschicht aus opakem Quarzglas gesintert.

Bei einer Abwandlung dieses Verfahrens gemäß der DE 10 2006 046 619 A1 wird das Fließverhalten des SiO₂-Schlickers durch Zusatz von SiO₂-Nanoteilchen in Richtung einer besseren Streichfähigkeit geändert. Bei einem Gewichtsanteil der SiO₂-Nanoteilchen am Gesamtfeststoffgehalt im Bereich von 0,2 Gew.-% bis 15 Gew.-% wird ein eher strukturviskos-thixotropes Fließverhalten des SiO₂-Schlickers erreicht, was dem Abfließen von gewölbten Oberflächen entgegenwirkt.

Einen ähnlichen Weg geht auch die WO 2011/042262 A2. Zur reproduzierbaren Herstellung einer Oberflächenschicht aus Quarzglas auf einem Basiskörper durch einfaches Aufsprühen einer Schlickerschicht wird ein Komposit-Schlicker vorgeschlagen, der splittrige SiO₂-Körnung, amorphe, sphärische SiO₂-Teilchen, SiO₂-Nanoteilchen und ein nichtionisches, alkalifreies Tensid enthält. Je höher der Anteil an sphärischen Teilchen ist, umso höher kann die Feststoffdichte in der Schlickerschicht eingestellt werden, was der Entstehung von Spannungen beim Trocknen und Sintern entgegenwirkt. Die Sprühfähigkeit verlangt aber dennoch einen relativ niedrigen Feststoffgehalt zwischen 74 bis 78 Gew.-%. Das Tensid setzt die Grenzflächenspannung herab und erhöht so die Viskosität des Schlickers bei geringen Scherspannungen.

Je nach Auftragstechnik und Oberflächenbeschaffenheit der Beschichtungsfläche des Bauteils können sich jedoch nach dem Sintern poröse Oberflächen ergeben, insbesondere wenn die Beschichtungsfläche selbst bereits porös ist. Um eine hinreichend dicke transparent verglaste Schicht und dichte Schicht zu erreichen, sind hohe Sintertemperaturen erforderlich, die leicht zu einer rauen, zerklüfteten Oberfläche führen.

### Technische Aufgabenstellung

Einer Erhöhung der Sinteraktivität der so erzeugten Schlickerschichten durch noch höhere Beladung des Schlickers mit SiO₂-Nanoteilchen sind jedoch Grenzen gesetzt. Die Fließeigenschaften des Schlickers verändern sich dabei in unzulässiger Weise. Zudem kommt bei hohen Gehalten an SiO₂-Nanoteilchen infolge stärkerer Schwindung beim Trocknen und Sintern zunehmend zu Schwindungsrissen.

Auch das Aufbringen mehrerer Schlickerschichten zur Erzeugung sukzessiv sinteraktiverer Körnungsschichten in Anlehnung an das oben beschriebenen Herstellungsverfahrens ist daher kaum weniger aufwändig.

Andererseits ermöglicht das Schlickergießverfahren, insbesondere das Aufsprühen der Schlickerschicht eine vergleichsweise kostengünstige Herstellung von Schichten. Aufgesprühte Schlickerschichten zeichnen sich darüber hinaus durch eine besonders homogene Verteilung der Teilchengrößen über die Schichtdicke aus. Es ist daher wünschenswert, dessen Nachteile bei der Herstellung dichter Schichten auf Quarzglas zu minimieren.

Grundsätzlich ist eine möglichst störungsfreie Schlickerschicht erwünscht. Ein Kriterium ist dabei, dass die Schicht nicht unter Einfluss der Gravitation wegfließt. Diese Eigenschaft der Schlickerschicht wird in der Praxis als "Tragen" bezeichnet; man sagt: "die Schicht trägt". Ein durch Aufsprühen zu verarbeitender Schlicker muss dünnflüssig sein. Damit die flüssige Schlickerschicht dennoch trägt, muss die Schichtdicke vergleichsweise dünn ausfallen.

Der Erfindung liegt daher die Aufgabe zugrunde, ein Verfahren zur Herstellung einer glatten, dichten Oberflächenschicht auf der Beschichtungsfläche eines Quarzglas-Bauteils anzugeben, die vergleichsweise kostengünstig und reproduzierbar bei Schichtdicken von mehr als 100 µm hergestellt werden kann; insbesondere auch dann, wenn die Beschichtungsfläche selbst porös ist.

### Allgemeine Darstellung der Erfindung

Diese Aufgabe wird ausgehend von dem eingangs genannten Verfahren erfindungsgemäß dadurch gelöst, dass das Aufbringen der SiO₂-Körnungsschicht gemäß Verfahrensschritt (b) umfasst:
(I) das Bereitstellen einer Dispersion, die eine Dispersionsflüssigkeit und amorphe SiO₂-Teilchen enthält, die eine Grobfraktion mit Teilchengrößen im Bereich zwischen 1 µm bis 50 µm sowie eine Feinfraktion aus SiO₂-Nanoteilchen mit Teilchengrößen von weniger als 100 nm bilden, wobei der Feststoffgehalt der Dispersion weniger als 80 Gew.-% beträgt und davon , im Bereich zwischen 2 bis 15 Gew.-% auf die SiO₂-Nanoteilchen entfallen,
(II) Aufbringen der Dispersion auf der Beschichtungsfläche durch Aufgießen oder Aufspritzen unter Ausbildung einer Schlickerschicht mit einer Schichtdicke von mindestens 0,3 mm, und
(III) Trocknen der Schlickerschicht, indem die Dispersionsflüssigkeit mit einer Rate und in einer Richtung abgezogen wird, derart, dass unter Wirkung der abziehenden Dispersionsflüssigkeit die Feinfraktion im Außenbereich der Körnungsschicht angereichert wird und dabei eine Gießhaut bildet.

Die getrocknete Schlickerschicht wird im Folgenden auch als "Grünschicht" bezeichnet. Sie stellt eine "Körnungsschicht" im Sine der Erfindung dar, die zur Ausbildung einer dichten Oberflächenschicht der thermischen Verdichtung durch Sintern bedarf. Die Sinterfähigkeit hängt stark von der Zusammensetzung der Schlickerschicht im oberflächennahen Bereich ab. Entscheidend ist dabei der Anteil an SiO₂-Nanoteilchen. Bei einem hohen Anteil ergibt sich eine höhere Sinteraktivität, die ein thermisches Verdichten bei vergleichsweise niedriger Temperatur oder kurzer Sinterdauer zu einem Glas mit höherer Dichte und geringer Porosität ermöglicht. Im Idealfall finden sich im oberflächennahen Bereich der Schlickerschicht nur relativ feine SiO₂-Teilchen.

Um dem nahe zu kommen, wird der Schlickerschicht beim erfindungsgemäßen Verfahren während des Trocknungsvorgangs ausreichend Gelegenheit zur Sedimentation gegeben. Die Sedimentation bewirkt innerhalb der erzeugten Schlickerschicht eine Zweiteilung in einen an die Beschichtungsfläche angrenzenden, unteren Bereich, in dem vorwiegend der Grobanteil der SiO₂-Teilchen zu finden ist, und in einen an die freie Oberfläche der Schicht angrenzenden Außenbereich, in dem die Feinfraktion angereichert ist. Die Feinfraktion der SiO₂-Teilchen wird von Nanoteilchen gebildet. Nanoteilchen bestehen typischerweise aus einem Verbund einiger Tausend SiO₂-Moleküle und haben üblicherweise eine spezifische Oberfläche nach BET im Bereich von 50 bis 400 m²/g. Im Unterschied zum eingangs genannten, bekannten Verfahren, das mehrere Schichtlagen unterschiedlicher Körnung erfordert, genügt beim erfindungsgemäßen Verfahren ein einziger Schichtauftrag; die Trennung der Teilchen unterschiedlicher Teilchengrößen erfolgt hier durch Sedimentation und andere physikalische Effekte, die im Folgenden noch näher erläutert werden.

Die Schlickerschicht zeichnet sich durch eine inhomogene Teilchengrößenverteilung aus, wobei der Übergang zwischen unterem und oberem Bereich nicht fließend ist, sondern im Grünkörper bei mikroskopischer Betrachtung eine erkennbare Ausprägung hat. Entscheidende Parameter für das Gelingen dieser Sedimentation sind:
- Der anfängliche Flüssigkeitsgehalt des Schlickers - dieser muss ausreichend hoch sein, nämlich mindestens 20 Gew.-%, um eine hinreichende Beweglichkeit der SiO₂-Nanoteilchen innerhalb der Schlickerschicht zu gewährleisten.
- Die Art und Weise, wie die Schlickerschicht aufgebracht wird - diese wird nicht sukzessive aufgebaut, wie etwa beim Aufsprühen der Schlickerschicht - sondern sie wird in einem Arbeitsgang mit in einer Mindestdicke von 0,3 mm aufgegossen oder aufgespritzt. Dadurch wird zum einen ein hinreichend großes Reservoir an SiO₂-Nanoteilchen zur Verfügung gestellt und zum anderen wird ein zu schnelles Trocknen der Schicht verhindert, das einer ausreichenden Sedimentation und Gießhaut-Ausbildung entgegenwirken kann. Beim Auftragen der Schicht durch Aufgießen oder Aufspritzen erfolgt der Schlickerauftrag entweder als kontinuierlicher Strahl, also ohne Zerteilung in einzelne Tropfen, oder mit einem so geringen Zerteilungsimpuls, dass eine Verkleinerung des Tropfendurchmessers des Schlickers unter seine Gleichgewichtsgröße vermieden wird; sie liegt bei mindestens 1 mm. Daher kommt es zu keiner nennenswerten Verringerung des Flüssigkeitsgehalts des Schlickers beim Auftragen der Schlickerschicht. Die Schlickerschicht erhält dabei vorzugsweise ihre Endform unter Einwirkung eines Werkzeugs, wie etwa einer Rakel, einem Pinsel, einer Aufspritzdüse oder einer Spachtel. Durch streichende Einwirkung des Bearbeitungswerkzeugs wird die Schichtoberfläche etwas flüssiger, was das Anreichern von SiO₂-Nanoteilchen auch bei verhältnismäßig geringem Flüssigkeitsgehalt erleichtert. In dem Zusammenhang zeigt die Sprühbeschichtung gegenüber dem Aufgießen oder Aufspritzen einen weiteren Nachteil, da es infolge des mechanischen Impulses beim Sprühen durch Ausbildung von Suspensionstropfen mit Tropfendurchmessern unterhalb der Gleichgewichtsgröße im Bereich von typischerweise 1 bis 500 µm kommt, bei denen das Trocknen unweigerlich bereits in der Flugphase in nennenswerten Umfang einsetzt. Der Flüssigkeitsgehalt der durch Sprühen gebildeten Schlickerschicht unterscheidet sich daher merklich von demjenigen des Ausgangsschlickers. Der Flüssigkeitsverlust kann durch Erhöhen des anfänglichen Flüssigkeitsgehalts wegen dann zunehmender Entmischungstendenz nicht ohne weiteres kompensiert werden.
- Ein Anteil an SiO₂-Nanoteilchen, der hoch genug ist, um eine nennenswerte Anreicherung im Außenbereich der Schlickerschicht bewirken zu können - dieser liegt im Schlicker im Bereich von 1 bis 10 Gew.-%. Im Gegensatz zur Sprühschicht, die sich durch eine weitgehend homogene Verteilung der Teilchengrößen über die Schichtdicke auszeichnet, sind die nach dem erfindungsgemäßen Verfahren aufgetragenen Schlickerschichten inhomogen, indem sie einen Gradienten in der Teilchengrößenverteilung über die Schichtdicke zeigen, mit einer Anreicherung von SiO₂-Nanoteilchen im oberflächennahen Bereich - also in der Gießhaut. In der keramischen Verfahrenstechnik werden derartige Gießhäute häufig als Hinweis für eine unerwünschte Inhomogenität der Schlickerschicht betrachtet und in der Regel entfernt. Infolge dieser Anreicherung kann die Grünschicht jedoch leichter dichtgesintert werden als ohne sie. Das heißt, zum Dichtsintern sind eine geringere Sintertemperatur und/oder eine verkürzte Sinterdauer erforderlich als bei einer Sprühschicht mit homogener Teilchengrößenverteilung. Bei sehr hohen Anteilen an SiO₂-Nanoteilchen wird eine Tendenz zur Rissbildung beim Trocknen oder Sintern beobachtet.
- Die Art und Weise, wie die Dispersionsflüssigkeit entfernt wird - dies erfolgt langsam und gezielt in Richtung der freien Oberfläche, so dass die entweichende Flüssigkeit SiO₂-Nanoteilchen nach oben in den Außenbereich mitnehmen kann.

Dadurch wird innerhalb der Schlickerschicht ein besonders homogener, dichter und sinteraktiver oberflächennaher Volumenbereich mit einem relativ hohen Anteil an SiO₂-Nanoteilchen erzeugt, wobei der Anteil höher als der mittlere Anteil der SiO₂-Nanoteilchen in der Dispersionsschicht ist.

Das Anreichern der feineren SiO₂-Teilchen und insbesondere der Feinfraktion an der Oberfläche der Schlickerschicht ist visuell als Hautbildung erkennbar, was hier auch als "Gießhaut" bezeichnet wird. Die Schlickerschicht wirkt visuell gegebenenfalls wie von einer Wachsschicht überzogen.

Die Gießhaut ist auch nach dem Trocknen (in der Grünschicht) erkennbar. Als Gießhaut wird dabei derjenige Oberflächenbereich der Schlickerschicht verstanden, der eine geringe Porosität von weniger als 10% bei einer mittleren Porengröße von weniger als 1 µm aufweist. Die Dicke dieser Schicht liegt bevorzugt im Bereich von 3 bis 15 µm, besonders bevorzugt im Bereich von 5 bis 10 µm.

Weiterhin zeichnet sich die Gießhaut dadurch aus, dass die Feinfraktion aus SiO₂-Nanoteilchen mit Teilchengrößen von weniger als 100 nm einen Volumenanteil der Gießhaut von mehr als 70 %, bevorzugt einen Volumenanteil von mehr als 80 % ausmachen.

Die SiO₂-Nanoteilchen liegen in der Gießhaut in der Regel nicht vereinzelt, sondern in Form von Aggregaten oder Agglomeraten vor, die die wenigen SiO₂-Teilchen der Grobfraktion teilweise oder vollständig einbetten. Da die Porosität der Gießhaut gering ist, entspricht der Volumenanteil ungefähr dem Gewichtsanteil der SiO₂-Nanoteilchen. Ein Volumenanteil von mehr als 70 % in der Gießhaut entspricht demnach einer Anreicherung um mehr als dem10-fachen gegenüber einem typischen Ausgangs-Schlicker des erfindungsgemäßen Verfahrens mit einem Gewichtsanteil von 7 % oder weniger an SiO₂-Nanoteilchen.

Bereits ein mäßiges Sintern (das heißt: vergleichsweise niedrige Sintertemperatur und/oder kurze Sinterdauer) führt zu einer nennenswerten und für die meisten Anwendungen ausreichenden Verdichtung. Im Bereich der ehemaligen Gießhaut verbleibt eine geschlossene Porosität von maximal 10 %.

Es hat sich gezeigt, dass eine Schlickerschicht, die beim Trocknen eine ungestörte Gießhaut zeigte, danach reproduzierbar und bei niedriger Temperatur zu einer dichten, transparenten Quarzglasschicht mit verhältnismäßig geringer Oberflächenrauigkeit gesintert werden konnte. Die mittlere Rauigkeit Rₐ der gesinterten Gießhaut beträgt in der Regel weniger als 5 µm, besonders bevorzugt weniger als 3 µm. Dies ist zunächst überraschend, denn bekanntlich zeigen SiO₂-Nanoteilchen zwar eine hohe Sinteraktivität, was die vergleichsweise niedrige Sintertemperatur erklärt, andererseits bewirken sie in hoher Konzentration jedoch auch eine hohe Trockenschwindung, und zwar in lateraler Richtung (in der Schichtebene) und können so zu Delamination der Schicht und zu Rissbildung führen.

Dass diese Effekte beim erfindungsgemäßen Verfahren normalerweise nicht auftreten, kann mit einer guten Verzahnung zwischen Gießhaut und übriger Grünschicht durch die größeren SiO₂-Teilchen erklärt werden.

Das Substrat besteht aus dotiertem oder undotiertem Quarzglas. Das Quarzglas ist synthetisch hergestellt oder aus natürlich vorkommenden Rohstoffen erzeugt. Es ist transparent oder opak (transluzent). Die Beschichtungsfläche selbst ist integraler Bestandteil des Substrats oder sie bildet selbst eine Beschichtung des Substrats.

Neben der Zusammensetzung der Schlickerschicht und der Art und Weise ihres Auftrags auf die Beschichtungsfläche ist das Entfernen der Dispersionsflüssigkeit ein entscheidender Parameter zur Ausbildung der dichten Gießhaut. In dem Zusammenhang ist bevorzugt eine Maßnahme vorgesehen, die bewirkt, dass die Schlickerschicht langsamer trocknet als ohne die Maßnahme, wobei die Maßnahme das Befeuchten der Beschichtungsfläche vor dem Aufbringen der Dispersion gemäß Verfahrensschritt (II) umfasst.

Ein verlangsamtes Trocknen kann im einfachsten Fall dadurch erreicht werden, dass das Trocknen in einer Umgebung mit einer gegenüber dem Standard erhöhten Feuchtigkeit oder bei vergleichsweise geringer Temperatur geschieht. Häufig wird zum Trocknen die Temperatur des Substrats erhöht, beispielsweise auf mehr als 100 °C; diese Temperaturerhöhung kann entfallen. Zum Gewährleisten einer ausreichenden Sedimentation der SiO₂-Nanotteilchen an der Oberfläche und zur Ausbildung einer Gießhaut hat sich eine anfängliche Trocknungsdauer von mindestens 2, vorzugsweise mindestens 3 Minuten besonders bewährt.

Insbesondere bei einer porösen Beschichtungsfläche ist ein Befeuchten vor dem Aufbringen der Dispersion gemäß Verfahrensschritt (II) hilfreich, um eine Verringerung der Trocknungsgeschwindigkeit zu erreichen. Das vorherige Befeuchten trägt in dem Fall auch dazu bei, offene oder geschlossene Poren vorab mit Flüssigkeit aufzufüllen, so dass deren Saugeffekt beim anschließenden Aufbringen der Schlickerschicht reduziert ist. Denn der Entzug der Dispersionsflüssigkeit soll möglichst vollständig in Richtung der freien Oberfläche erfolgen, damit SiO₂-Nanoteilchen von der Flüssigkeit in diese Richtung mitgenommen werden können. Bei einem Saugeffekt infolge von Poren würden SiO₂-Nanoteilchen in umgekehrter Richtung abtransportiert. Deswegen ist die denkbare Alternative, nämlich ein Erhöhen des Flüssigkeitsanteils der Dispersion zum Ausgleich des Saugeffektes eher unwirksam und könnte außerdem wegen sehr hohem Flüssigkeitsanteil zur Instabilität der Dispersion führen. Die Flüssigkeit zum Befeuchten der Beschichtungsfläche ist die Dispersionsflüssigkeit oder eine andere Flüssigkeit. Die poröse Beschichtungsfläche ergibt sich beispielsweise aufgrund der Porosität des zu beschichtenden Bauteils oder aufgrund der Porosität einer Oberflächenschicht des Bauteils.

Es hat sich auch als günstig erweisen, wenn die Schlickerschicht mechanisch verdichtet wird.

Beim mechanischen Verdichten wird das vorhandene Lückenvolumen zwischen den SiO₂-Teilchen verkleinert und die darin vorhandene Dispersionsflüssigkeit wird herausgepresst und sammelt sich an der freien Oberfläche an. Bei diesem Vorgang kann sie SiO₂-Nanoteilchen mitreißen und zur Oberfläche der Schlickerschicht transportieren. Dadurch bildet sich an der Oberfläche ein Flüssigkeitsfilm, der SiO₂-Nanoteilchen enthält und der beim Abtrocknen leicht eine Gießhaut bildet. Darüber hinaus ergibt sich durch das mechanische Verdichten auch ein engerer Kontakt der SiO₂-Teilchen untereinander, was eine höhere Grünfestigkeit der Schlickerschicht nach dem Trocknen und eine bessere Verzahnung mit dem Substrat bewirkt. Die nach dem Trocknen der Schlickerschicht verbleibende Porosität beträgt vorzugsweise weniger als 10%.

Das Verdichten kann unmittelbar beim Auftragen der Schlickerschicht erfolgen. Geeignete Methoden erzeugen in der Schicht Druck- oder Scherkräfte, wie beispielsweise Streichen oder Rakeln.

Es hat sich bewährt, wenn die Schlickerschicht mit einer Schichtstärke von maximal 3 mm, vorzugsweise maximal 1,5 mm erzeugt wird und wenn die Dispersion bezogen auf ihren gesamten Feststoffgehalt einen Gewichtsanteil an SiO₂-Nanoteilchen von maximal 10 % enthält.

Bei Schichtdicken von mehr als 3 mm oder bei hohen Gewichtsanteilen an SiO₂-Nanoteilchen von mehr als 10% steigt das Risiko von Schwindungsrissen beim Trocknen und Sintern. Dies kann damit erklärt werden, dass es zur Vermeidung von Rissbildung auf eine gewisse Durchdringung der Grünschicht mit gröberen SiO₂-Teilchen ankommt, die zur Verzahnung der Gießhaut beitragen und so einem Reißen beim Trocknen oder Sintern entgegenwirken. Daher liegt die bevorzugte Dicke der Schlickerschicht nicht wesentlich höher als der D₅₀-Wert der Teilchengrößenverteilung im Grobanteil der SiO₂-Teilchen.

Bevorzugt ist die Grobfraktion splittrige, amorphe SiO₂-Körnung mit einer Korngrößenverteilung mit einem D₅₀-Wert im Bereich zwischen 3 µm und 30 µm.

Die splittrige SiO₂-Körnung trägt zur Integrität der Schlickerschicht und zur Verzahnung mit der Oberfläche bei und verbessert deren Haftung. Die Wirkung hinsichtlich Verzahnung und Haftverbesserung wird am besten bei einer spezifischen Korngrößenverteilung erreicht, die einen D₅₀-Wert zwischen 3 µm und 30 µm hat. Bei einem D₅₀-Wert von weniger als 3 µm ergibt sich nennenswert erhöhte Trockenschwindung der Schlickerschicht, und Körnung mit einem D₅₀-Wert von mehr als 30 µm wirkt einer hohen Feststoffdichte im Schlicker entgegen, was ebenfalls zu einer erhöhten Trockenschwindung beiträgt. Die splittrige Körnung wird am einfachsten durch Mahlen hergestellt, vorzugsweise durch Nassmahlen.

Die Dispersionsflüssigkeit besteht vorzugsweise auf wässriger Basis.

Die polare Natur der wässrigen Phase kann sich auf die Wechselwirkung der SiO₂-Teilchen vorteilhaft auswirken.

Als besonders günstig hat sich ein Feststoffgehalt der Dispersion im Bereich zwischen 70 bis 80 Gew.-%, vorzugsweise zwischen 74 und 78 Gew.-% erwiesen.

Hierbei handelt es sich um einen relativ geringen Feststoffgehalt, wie er beispielsweise für Sprühschlicker typisch ist. Die Sprühfähigkeit erfordert eine niedrige Viskosität und damit einen niedrigen Feststoffgehalt. Andererseits ist ein so geringer Feststoffgehalt ist an und für sich unerwünscht, weil er zu einer höheren Schwindung der Schlickerschicht und zu Rissbildung führen kann. Der geringe Feststoffgehalt erleichtert jedoch den Transport von SiO₂-Nanoteilchen in den Außenbereich der Schlickerschicht, so dass er beim erfindungsgemäßen Verfahren bevorzugt wird, selbst wenn die Dispersion nicht als Sprühschlicker eingesetzt wird, sondern eine andere Auftragstechnik angewandt wird, wie etwa Aufstreichen oder Aufrakeln, was den Einsatz einer Dispersion mit höheren Feststoffgehalten erlauben würde.

Nach dem Trocknen der Schlickerschicht wird die "Grünschicht" erhalten. Das Sintern oder Sintern der getrockneten Grünschicht erfolgt durch Erhitzen in einem Ofen, oder mittels einer Verbrennungsflamme, mittels Plasma oder Lichtbogen oder mittels eines Lasers mit einer vorgegebenen Arbeitswellenlänge. Dabei kann die Grünschicht eine Komponente enthalten, welche die Arbeitswellenlänge der Laser- oder Plasmastrahlung absorbiert, so dass die Hitzeeinwirkung beim Verdichten zeitlich kurz und lokal beschränkt, und plastische Verformungen oder das Einbringen von thermischen Spannungen weitgehend vermieden werden können. Bei der die Plasma- oder Laserstrahlung bevorzugt absorbierenden Komponente handelt es sich um einen Zusatzstoff in Form von Teilchen anderen chemischen Zusammensetzung als SiO₂ oder um eine Dotierung der amorphen SiO₂-Teilchen, oder es handelt sich um Grenzflächen, an denen die Plasma- oder Laserstrahlung diffus reflektiert und dadurch absorbiert wird.

Die gesinterte SiO₂-Oberflächenschicht ist je nach Anwendung transparent oder vollständig oder teilweise opak und zeichnet sich jedem Fall durch Rissfreiheit und durch hohe Haftfestigkeit auf dem Quarzglas des Basiskörpers aus. Sie ist in der Regel in Form einer ebenen Schicht ausgeführt, sie kann aber auch eine Geometrie haben, die einen funktionellen Bestandteil des Substrats ausmacht, beispielsweise als Verdickung oder Wulst.

Der SiO₂-Gehalt der amorphen SiO₂-Teilchen beträgt vorzugsweise mindestens 99,99 Gew.-%. Dies gilt sowohl für die splittrige SiO₂-Körnung aus auch für sphärische SiO₂-Teilchen. Der Feststoffanteil des unter Einsatz derartiger SiO₂-Partikel hergestellten Schlickers besteht zu mindestens 99,99 Gew.-% aus SiO₂. Bindemittel oder dergleichen Zusatzstoffe sind nicht vorgesehen. Der Gehalt an metallischen Verunreinigungen beträgt vorzugsweise weniger als 1 Gew.-ppm. Eine Kontaminations- oder Kristallisationsgefahr geht von diesem Ausgangsmaterial nicht aus. Der Cristobalit-Anteil in der getrockneten SiO₂-Schlickerschicht (=Grünschicht) sollte höchstens 1 Gew.-% betragen, da es andernfalls beim Sintern zur Kristallisation kommen kann, was eine Verdichtung verhindern und zum Ausschuss des Bauteils führen kann.

Vorzugsweise wird eine Dispersion eingesetzt, die frei von Bindemitteln ist.

Durch die Bindemittelfreiheit wird der Eintrag von Verunreinigungen in den Schlicker vermieden. Das Sintern erfolgt vorzugsweise ohne Zuhilfenahme von Sinterhilfsmitteln. Die so erzeugten Schichten zeichnen sich durch hohe Reinheit aus. Es werden SiO₂-Gehalte von mehr als 99,99% erreicht. Vor allem Alkalielemente, die entweder als Bestandteil oder auch als Verunreinigungen in den Binderzusätzen vorkommen können, führen bei erhöhten Temperaturen zur Bildung der kristallinen Phase Cristobalit. Solche Entglasungsvorgänge führen bei Temperaturwechseln zur Rissbildung und sie können außerdem die Verdichtung im Sinterprozess behindern.

### Ausführungsbeispiel

Nachfolgend wird die Erfindung anhand von Ausführungsbeispielen und einer Zeichnung näher erläutert. Dabei zeigt im Einzelnen
- **Figuren 1 bis 5**: Fotos von Grünschichten unterschiedlicher Proben in gleicher Vergrößerung,
- **Figur 6**: ein Diagramm mit Messergebnissen der mittleren Rauigkeit von Oberflächenschichten unterschiedlicher Proben,
- **Figur 7**: eine hochaufgelöste computer-tomographische Aufnahme (Mikro-CT-Aufnahme) einer nach dem erfindungsgemäßen Verfahren erzeugten Grünschicht in einer Seitenansicht,
- **Figur 8**: eine Mikro-CT-Aufnahme einer durch Aufsprühen und Trocknen einer Schlickerschicht erzeugten Grünschicht in einer Seitenansicht, und
- **Figur 9**: Eine rasterelektronenmikroskopische Aufnahme auf eine Bruchkante bei einer Grünschicht gemäß der Erfindung.

### Herstellen eines SiO₂-SchlickerSchlickers

In eine Dispersionsflüssigkeit werden in einer mit Quarzglas ausgekleideten Trommelmühle eine amorphe Quarzglaskörnung aus natürlichem Rohstoff mit Korngrößen im Bereich zwischen 250 µm und 650 µm eingemischt. Die Quarzglaskörnung wurde vorab in einem Heißchlorierverfahren gereinigt; es wird darauf geachtet, dass der Cristobalitgehalt unter 1 Gew.-% liegt.

Diese Mischung wird mittels Mahlkugeln aus Quarzglas auf einem Rollenbock bei 23 U/min während einer Dauer von 3 Tagen soweit vermahlen, dass sich ein homogener Schlicker bildet. Im Verlauf des Vermahlens kommt es infolge des in Lösung gehenden SiO₂ zu einer Absenkung des pH-Werts auf etwa 4.

Die nach dem Vermahlen der Quarzglaskörnung erhaltenen SiO₂-Körnungsteilchen sind splittriger Natur und zeigen eine Teilchengrößenverteilung, die durch einen D₅₀- Wert von etwa 8 µm und durch einen D₉₀-Wert von etwa 40 µm gekennzeichnet ist. Dem homogenen Schlicker werden SiO₂-Nanoteilchen mit Durchmessern um 40 nm ("pyrogene Kieselsäure") hinzugefügt. Nach weiterer Homogenisierung wird ein bindemittelfreier SiO₂-Schlicker erhalten.

Mit SiO₂-Schlickern unterschiedlicher aber ähnlicher Zusammensetzung wurden Beschichtungsproben auf unterschiedlichem Untergrund und anhand unterschiedlicher Auftragstechniken erzeugt. Die Zusammensetzung der jeweiligen Schlicker und die damit erzielten Beschichtungsergebnisse sind in Tabelle 1 angegeben:

### Probe 1 (Vergleichsbeispiel)

Der SiO₂-Schlicker hat eine geringe Viskosität und ist an und für sich unmittelbar als Sprühschlicker einsetzbar. In einem ersten Versuch wurde dieser Schlicker zur Herstellung einer Beschichtung auf einer porösen Platte eingesetzt. Die Platte besteht aus saugfähigem, opakem Quarzglas mit offener Porosität.

Zur Beschichtung wurde die Quarzglas-Platte in horizontaler Orientierung in eine Sprühkammer eingebracht und die Oberseite sukzessive durch Aufsprühen des Schlickers mit einer tragenden ca. 0,7 mm dicken SiO₂-Schlickerschicht versehen. Hierfür wurde eine Sprühpistole eingesetzt, der kontinuierlich der Sprühschlicker zugeführt wird.

Auf der so sukzessive aufgebrachten Schlickerschicht bildet sich beim nachfolgenden Antrocknen an Luft innerhalb einer Minute eine raue und zerklüftete Oberflächenschicht. Dieses Ergebnis wird jedenfalls teilweise darauf zurückgeführt, dass das Trocknen der Schlickerschicht wegen des porösen Untergrundes so rasch erfolgte, dass eine Sedimentation des Feinanteils im oberen Bereich der Schlickerschicht nicht möglich war, so dass sich keine dichte und geschlossene Gießhaut ausbilden konnte.

Das weitere Trocknen erfolgte dann langsam, indem die Schlickerschicht an Luft acht Stunden lang ruht. Die vollständige Trocknung erfolgt unter Einsatz eines IR-Strahlers an Luft während 4Stunden.

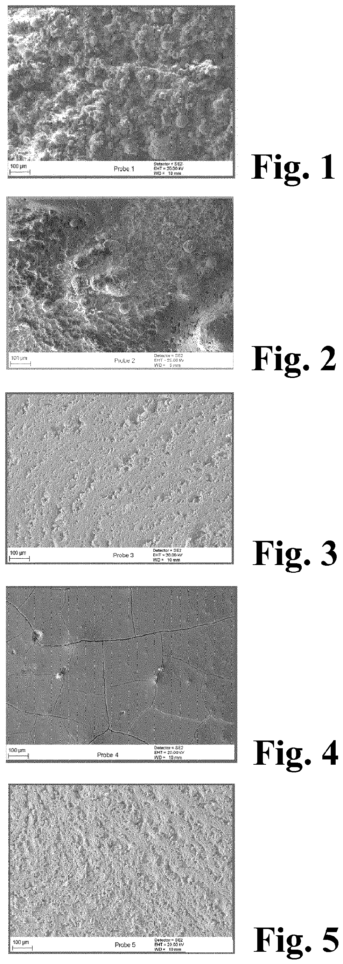

Es wird eine raue und rissige inhomogene Oberflächenschicht aus opakem, porösem Quarzglas erhalten, die das in **Figur 1** gezeigte Erscheinungsbild hat.

Die getrocknete Grünschicht wird anschließend in einem Sinterofen bei einer Temperatur um 1400 °C zu einer opaken Oberflächenschicht mit einer Dichte von etwa 1,9 g/cm³ gesintert.

### Probe 2 (Vergleichsbeispiel)

Um den Effekt des porösen Untergrundes auf das Trocknen auszuschließen, wurde bei einem weiteren Versuch anstelle der porösen Quarzglas-Platte eine Quarzglas-Platte mit dichter, glatter Oberfläche eingesetzt. Da die Schlickerschicht hierbei leicht verläuft, wurde ein etwas höherer Feststoffgehalt als bei Probe 1 eingestellt und die Enddicke der Schlickerschicht betrug hier nur 0,4 mm. Ansonsten wurden die Fertigungsparameter wie bei Probe 1 beibehalten.

Im Ergebnis wurde nach dem Antrocknen der Schlickerschicht an Luft eine Oberflächenschicht erhalten, deren Erscheinungsbild **Figur 2** in einer Draufsicht zeigt. Sie ist etwas weniger rau und inhomogen ist als diejenige von Probe 1. Die Verbesserung ist aber verhältnismäßig geringfügig.

Dass die Verbesserung so gering ausfällt, kann damit erklärt werden, dass sich die anfängliche Trocknungsrate der Schlickerschichten bei den Proben 1 und 2 trotz des nicht-saugfähigen Untergrundes bei Probe 2 nicht nennenswert unterscheidet. Dies kann nur auf die Auftragstechnik selbst zurückgeführt werden. Denn beim Aufsprühen werden feine Tropfen des Schlickers erzeugt, die bereits während ihrer Flugphase Feuchtigkeit verlieren. Darüber hinaus wird die Schlickerschicht sukzessive in mehreren Lagen aufgebaut. Die einzelnen Lagen sind dünn und trocknen an Luft unmittelbar an. Nur so gelingt mit dem dünnflüssigen Sprühschlicker überhaupt ein Schichtaufbau mit ausreichender Dicke. Dadurch steht aber ein hinreichend großes Reservoir an SiO₂-Nanoteilchen für eine Sedimentation des Feinanteils an der Oberfläche der Sprühschicht nicht zur Verfügung.

Das weitere Trocknen und Sintern erfolgt wie oben anhand Probe 1 beschrieben.

### Probe 3

Wie bei Probe 1 soll auf einer ebenen Platte aus saugfähigem, opakem Quarzglas mit offener Porosität eine SiO₂-Oberflächenschicht mit einer Stärke von 2 mm erzeugt werden.

Im Unterschied zu Probe 1 wird die Schlickerschicht durch Aufrakeln (auch als "Aufgießen" zu bezeichnen) erzeugt. Hierbei wird auf der horizontal gelagerten Quarzglas-Platte eine ca. 4 mm dicke SiO₂-Schlickerschicht aufgerakelt, und unmittelbar danach wird mittels der Rakeleinrichtung ein so hoher Druck auf die Schlickerschicht ausgeübt, so dass sie sich auf eine Dicke von ca. 0,8 mm verdichtet.

Auf der so aufgebrachten und verdichteten Schlickerschicht bildet sich ein dünner Flüssigkeitsfilm und beim nachfolgenden Antrocknen an Luft eine homogene und geschlossene Oberflächenschicht aus. Eine mikroskopische Betrachtung zeigt einen hohen sedimentierten Feinanteil. Das heißt, der innerhalb der Gießhaut ist der Anteil feiner SiO₂-Teilchen und insbesondere von SiO₂-Nanoteilchen nennenswert höher als im Rest der Schlickerschicht.

Die Art und Weise des Auftragens der kompletten Schichtdicke in einem Arbeitsgang stellt zum einen ein hinreichend großes Reservoir an SiO₂-Nanoteilchen auf einmal zur Verfügung, das zur Sedimentation an der Oberfläche geeignet ist, und zum anderen wird ein zu schnelles Trocknen der Schicht an Luft verhindert, das andernfalls der Sedimentation und Gießhaut-Ausbildung entgegenwirken würde. Daher ergibt sich bei Probe 3 trotz anfänglich etwas geringerem Feststoffgehalt und ansonsten ähnlichen Prozessparametern wie bei Probe 1 eine langsamere Trocknung von etwa 3 bis 5 min und eine Verfestigung der Schlickerschicht zur tragenden Schicht, die die Ausbildung einer im Wesentlichen glatten Gießhaut ermöglicht.

Beim Aufgießen enthält die Schlickerschicht ihre Endform unter Einwirkung eines Werkzeugs, wie etwa einer Rakel, einem Pinsel, einer Spachtel oder einer Auslaufdüse, aus der beim Auftragen ein kontinuierlicher Schlickerstrahl ausläuft. Durch streichende Einwirkung des Bearbeitungswerkzeugs wird die Schichtoberfläche etwas flüssiger, was das Anreichern von SiO₂-Nanoteilchen auch bei verhältnismäßig geringem Flüssigkeitsgehalt erleichtert. Dieses Ergebnis - das heißt, keine nennenswerte Verringerung des Flüssigkeitsgehalts des Schlickers - ist auch bei anderen Auftragstechniken (wie Aufspritzen) zu erwarten, bei denen die Schlickerschicht in ihrer gesamten Dicke auf einmal und ohne Zerteilung in feine Tropfen von weniger als 1 mm erzeugt wird.

Die so erzeugte Schlickerschicht wird innerhalb von 3 Minuten zu einer tragenden Schicht und anschließend weiter langsam getrocknet, indem sie an Luft 1 Stunde ruht. Dabei erhält die Gießhaut ein wachsartiges Erscheinungsbild. Die vollständige Trocknung erfolgt unter Einsatz eines IR-Strahlers an Luft während 4 bis 8 Stunden, wonach sie das in **Figur 3** gezeigte Erscheinungsbild hat.

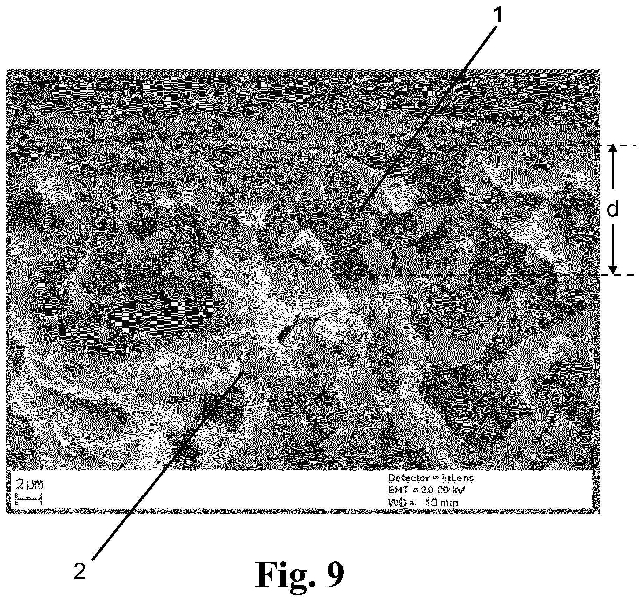

Die Oberfläche wirkt im Wesentlichen glatt. Die glatten Oberflächenbereiche werden von SiO₂-Feinanteil gebildet, also von SiO₂-Nanoteilchen und deren Agglomeraten oder Aggregaten. Die rauen Oberflächenbereiche werden von SiO₂-Gronanteil erzeugt (siehe hierzu auch Figur 9). Eine Auswertung der Oberflächentextur mittels Bildanalyse ergibt einen Glattanteil von etwa 85 % an der Gesamtfläche. Bei Betrachtung der Oberflächenschicht im seitlichen Anschnitt ist - wenn auch in schwach Ausprägung - eine Hautschicht (Gießhaut) mit einer Dicke von etwa 9 µm erkennbar (siehe Figur 9).

Die im Oberflächenbereich der getrockneten Schlickerschicht angereicherten SiO₂-Nanoteilchen zeigen eine hohe Sinteraktivität und verbessern die Verdichtung der Schicht. Beim Sintern der getrockneten Grünschicht in einem Sinterofen bei einer Temperatur um 1400 °C wird die Schicht zunächst dicht und danach geschlossen-porös. Es wird eine rissfreie und im Wesentlichen glatte Oberflächenschicht aus opakem Quarzglas mit einer Dichte von etwa 2,1 g/cm³ und dementsprechend einer Porosität von 5% erhalten.

### Probe 4

Es wurde ein weiterer Versuch durchgeführt wie anhand Probe 3 beschrieben wobei anstelle der porösen Quarzglas-Platte als Substrat eine Quarzglas-Platte mit dichter, glatter Oberfläche eingesetzt wurde. Um dem Ablaufen der Schlickerschicht entgegen zu wirken wurden die Gehalte an SiO₂-Nanoteilchen und Feststoff insgesamt erhöht.

Im Ergebnis wurde nach dem Antrocknen der Schlickerschicht an Luft eine Oberflächenschicht erhalten, deren Rauheit noch geringer war wie diejenige von Probe 3, die aber Risse enthielt, wie **Figur 4** zeigt. Dieses an und für sich überraschende Ergebnis ist dadurch zu erklären, dass wegen des nicht saugenden Untergrundes das Antrocknen zur tragenden Schicht hier länger dauert. Dies führt zu einer verstärkten Anreicherung der SiO₂-Nanoteilchen im oberen Bereich der Schlickerschicht, also zu einer vergleichsweise dicken Gießhaut im Sinne der Erfindung. Dieser Effekt kann zu einer starken Trockenschwindung und damit zur Rissbildung führen. Bei Betrachtung der Oberflächenschicht im seitlichen Anschnitt ist - wenn auch in schwach Ausprägung - eine Hautschicht (Gießhaut) mit einer Dicke von etwa 6 µm erkennbar. Dabei sind grobkörnige SiO₂-Teilchen nahezu vollständig in eine Masse aus feinteiligem SiO₂ eingebettet, so dass sie die Oberfläche nicht durchstoßen, was die besonders glatte Oberflächenschicht von Probe 4 erklärt. Die Auswertung der Oberflächentextur mittels Bildanalyse ergibt hier einen Glattanteil von fast 100 % an der Gesamtfläche

Die Rissbilddung zeigt aber auch, dass zum Erreichen eines optimalen Ergebnisses in Bezug auf die Oberflächenqualität die anfängliche Trocknungsgeschwindigkeit ein wichtiger Parameter für die Ausbildung einer optimal dicken Gießhaut ist. Eine anfängliche Trocknungsdauer bis zum Erreichen einer tragenden Schicht von etwa 2 bis maximal 5 Minuten erweist sich als optimal. In dem Zusammenhang ist wiederum die Saugfähigkeit des Untergrundes ein entscheidender Parameter.

Das Trocknen und Sintern erfolgt wie oben anhand Probe 3 beschrieben. Es wurde eine dichte Oberfläche erhalten. Dies zeigt, dass die nach dem Trocknen erhaltenen Risse auf den oberflächennahen Bereich, möglicherweise auf die Gießhaut selbst - beschränkt waren.

### Probe 5

In einem weiteren Versuch sollte das bei Probe 3 erreichte Ergebnis optimiert werden. Auf einer ebenen Platte aus saugfähigem, opakem Quarzglas mit offener Porosität, soll eine SiO₂-Oberflächenschicht mit einer Stärke von 2 mm erzeugt werden.

Im Unterschied zu Probe 3 wurde die Quarzglas-Platte zunächst 5 Minuten lang in einem Ultraschallbad in horizontaler Orientierung gewässert, so dass die nach außen offenen Poren weitgehend mit Wasser füllten. Die Quarzglas-Platte wird anschließend im Ultraschallbad angehoben, so dass ihre Oberseite über den Flüssigkeitsspiegels des Bades ragt.

Bei eingeschalteter Ultraschall-Vibration wird auf der weiterhin horizontal gelagerten Quarzglas-Platte eine ca. 0,8 mm dicke SiO₂-Schlickerschicht aufgerakelt. Dabei wird mittels der Rakeleinrichtung ein möglichst hoher Druck ausgeübt, so dass sich die Schlickerschicht auf eine Dicke von ca. 0,7 mm verdichtet.

Auf der so aufgebrachten und verdichteten Schlickerschicht bildet sich ein dünner Flüssigkeitsfilm und beim nachfolgenden Antrocknen an Luft eine homogene und geschlossene Oberflächenschicht aus. Auch nach dem weiteren Trocknen wie anhand Probe 3 beschrieben, bleibt die Schicht im Wesentlichen glatt und gleicht in ihrem Erscheinungsbild derjenigen von Probe 3 wie Figur 5 zeigt. Auch hier ergibt die Bildanalyse einen hohen Glattanteil im Bereich von etwa 75% an der Gesamtfläche

Bei mikroskopische Betrachtung der Oberflächenschicht im seitlichen Anschnitt zeigt sich - wenn auch in schwach Ausprägung - eine Hautschicht (Gießhaut) mit einer Dicke von etwa 4 µm. Innerhalb dieser Gießhaut ist der Anteil von SiO₂-Nanoteilchen nennenswert höher als im Rest der Grünschicht und macht deutlich mehr als 70 % des Volumens der Gießhaut aus.

Die im Oberflächenbereich der getrockneten Schlickerschicht angereicherten SiO₂-Nanoteilchen zeigen eine hohe Sinteraktivität und verbessern die Verdichtung der Schicht beim nachfolgenden Sintern. Es wird eine rissfreie, homogene Schicht aus opakem Quarzglas mit einer Dichte von etwa 2,1 g/cm³, entsprechend einer Porosität von 5% erhalten.

### Probe 6

In einem weiteren Versuch sollte überprüft werden, ob das bei Probe 5 erreichte Ergebnis auch bei einem anderen saugfähigen Untergrund erreichbar ist. Zu diesem Zweck wurde auf einer Platte aus Quarzglas zunächst eine Oberflächenschicht aus porösem SiO₂ mit einer Dicke von 1,5 mm erzeugt. Die poröse Oberflächenschicht wurde durch Aufsprühen einer Schlickerschicht und anschließendem Trocknen der Schlickerschicht und Sintern gemäß Probe 2 erzeugt. Das Volumen dieser Oberflächenschicht und damit ihre Saugwirkung für Wasser sind etwas geringer als bei Probe 5.

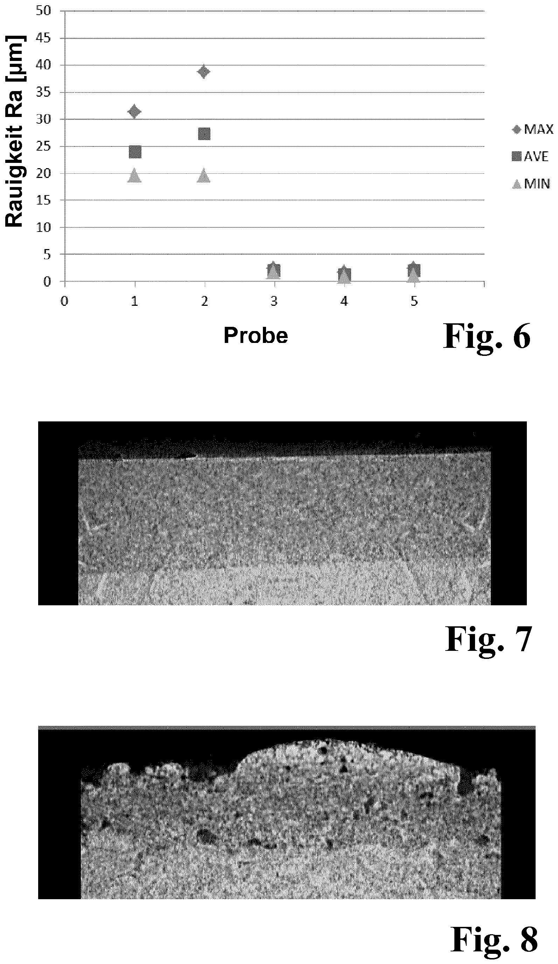

Auf der so vorbehandelten Oberflächenschicht wurde eine Schlickerschicht mit dem Schlicker von Probe 5 und der anhand dieser Probe erläuterten Verfahrenstechnik beim Trocknen und Sintern erzeugt. Ein nennenswerter Unterschied der so erhaltenen Oberflächenschicht gegenüber der von Probe 5 wurde nicht festgestellt. Das Diagramm von **Figur 6** zeigt die Oberflächenrauigkeiten (Rₐ-Wert) der Grünschicht-Proben 1 bis 5, und zwar jeweils an unterschiedlichen Messstellen gemessene Maxima, Minima und Mittelwerte für den Ra-Wert (mittlere Oberflächenrauigkeit).

Daraus ergibt sich, dass nach dem Trocknen die aufgesprühten Schlickerschichten gegenüber den durch Aufrakeln erzeugten Oberflächenschichten eine vergleichsweise hohe mittlere Rauigkeit zeigen. Die niedrigste Oberflächenrauigkeit wird bei Probe 4 erreicht; die jedoch Risse zeigt. Diese Risse wirken sich jedoch auf den Rₐ-Wert nicht nennenswert aus. Ein Bauteil mit dieser Oberfläche Probe ist für Anwendungen einsetzbar bei denen eine glatte, aber keine dichte Oberfläche erforderlich ist. Den zweitniedrigsten Wert der Oberflächenrauigkeit erreicht Probe Nr. 5

Die Mikro-CT-Aufnahmen der **Figuren 7 und 8** zeigen in jeweils gleicher Vergrößerung (etwa 50-fach) Querschnitte der Grünschichten der Proben 1 und 5. Demnach zeigt die Probe 1 (Figur 8) eine zerklüftete und ungleichmäßige Oberfläche, wohingegen die Oberfläche von Probe 5 (Figur 7) im Wesentlichen glatt ist. Bei genauer Betrachtung ist erkennbar, hebt sich ein dünner Bereich der Oberfläche etwas ab, der auf die Gießhaut zurückzuführen ist.

Besser erkennbar ist diese Oberflächenschicht bei der Ansicht auf eine Bruchkante bei Probe 5 gemäß **Figur 9****.** Hier hebt sich eine Gießhaut 1 mit besonders feinkörniger Struktur und mit einer Dicke d von etwa 9 µm vom Rest der Schicht 2 mit grobkörnigerer Struktur deutlich ab. Innerhalb der Gießhaut 1 sind grobkörnige Teilchen nahezu vollständig in einer Masse eingebettet, die aus feinteiligem SiO₂ besteht, die insbesondere aus SiO₂-Nanoteilchen und Agglomeraten davon gebildet wird. Der Volumenanteil dieser Masse an der etwa 9 µm dicken Gießhaut insgesamt liegt bei mehr als 75%.. Es ist auch erkennbar, dass grobkörnige SiO₂-Teilchen die Oberfläche kaum durchstoßen können, so dass eine im Wesentlichen glatte und dichte Oberflächenschicht erhalten wird, wie sie auch die Proben 3 und 6 zeigen.

In **Tabelle 1** sind die charakteristischen Herstellungsparameter und die Messergebnisse der Proben 1 bis 5 zusammengefasst.

**Tabelle 1**

| **Nr.** | **Flüssigkeit** | **F (Gew-%)** | **Soot (Gew-%)** | **Auftragstechnik** | **Substrat** | **Ra [µm]** | **Risse** | **Q** |
|---|---|---|---|---|---|---|---|---|
| **1** | DI | 74 | 5 | Sprühen | porös / saugfähig | 24,2 | Nein | Nein |
| **2** | DI | 77 | 9 | Sprühen | dicht / glatt | 27,1 | Nein | Nein |
| **3** | DI | 76 | 4 | Aufrakeln | porös / saugfähig | 1,8 | Nein | Ja |
| **4** | DI:ET = 70:30 | 78 | 7,5 | Aufrakeln | dicht/ glatt | 1,2 | Ja | Bedingt ja |
| **5** | DI:ET = 90:10 | 78 | 2,5 | Aufrakeln | porös / nicht saugfähig | 1,6 | Nein | Ja |
| **6** | DI:ET 90:10 | 76 | 2,5 | Aufrakeln | porös / wenig saugfähig | 1,8 | Nein | Ja |

| | | | | | | | | |
|---|---|---|---|---|---|---|---|---|
| Dabei bedeuten DI: Deionisiertes Wasser (als Teil der Dispersionsflüssigkeit) ET: Ethanol (als Teil der Dispersionsflüssigkeit - F: Gewichtsanteil der Feststoffe am Gesamtgewicht der Dispersion Soot: Gewichtsanteil der SiO₂-Nanoteilchen am Feststoffgehalt der Dispersion Rₐ: Mittelwert der Oberflächen-Rauheit der Oberfläche nach dem Sintern Q: Geeignete Oberfläche nach dem Sintern? | | | | | | | | |

Der Vergleich der Proben 1, 3, 5 und 6 einerseits und der Proben 2 und 4 andererseits zeigt, dass die Rauigkeit der Oberfläche ist von der Art des Untergrundes weitgehend unabhängig ist; entscheidend ist vielmehr die Auftragstechnik. Dabei ist wiederum die Trocknungsdauer der Schlickerschicht bis zur Ausbildung einer tragenden Schicht, beziehungsweise die verfügbare Sedimentationszeit von Bedeutung. Die Trocknungsdauer ergibt sich im Zusammenspiel von Feuchtigkeitsgehalt der Dispersion, Auftragstechnik und Dicke der Schlickerschicht. Eine lange Trockendauer führt grundsätzlich zur Ausbildung einer dichten Gießhaut und ist insoweit vorteilhaft, wenn es auf eine glatte Oberfläche ankommt. Bei sehr langer Trocknungsdauer kann es allerdings zu einer entsprechend sehr dicken Gießhaut und zu Rissbildung beim Trocknen kommen, wie Probe 4 zeigt.

## Patentansprüche

1. Verfahren zur Herstellung eines beschichteten Bauteils aus Quarzglas oder Quarzgut, umfassend folgende Verfahrensschritte:
(a) Bereitstellen eines Substrats aus Quarzglas oder aus Quarzgut, das eine Beschichtungsfläche aufweist,
(b) Aufbringen einer SiO₂-Körnungsschicht auf der Beschichtungsfläche, welche einen an die Beschichtungsfläche angrenzenden Innenbereich mit einem ersten Körnungs-Feinanteil und einen an die freie Oberfläche der Körnungsschicht angrenzenden Außenbereich mit einem zweiten Körnungs-Feinanteil aufweist, wobei der zweite Körnungs-Feinanteil höher ist als der erste Körnungs-Feinanteil,
(c) Sintern der Körnungsschicht unter Ausbildung einer dichten SiO₂-Oberflächenschicht,
**dadurch gekennzeichnet, dass** das Aufbringen der SiO₂-Körnungsschicht gemäß Verfahrensschritt (b) umfasst:
(I) das Bereitstellen einer Dispersion, die eine Dispersionsflüssigkeit und amorphe SiO₂-Teilchen enthält, die eine Grobfraktion mit Teilchengrößen im Bereich zwischen 1 µm bis 50 µm sowie eine Feinfraktion aus SiO₂-Nanoteilchen mit Teilchengrößen von weniger als 100 nm bilden, wobei der Feststoffgehalt der Dispersion weniger als 80 Gew.-% beträgt, und davon im Bereich zwischen 2 bis 15 Gew.-% auf die SiO₂-Nanoteilchen entfallen,
(II) Aufbringen der Dispersion auf der Beschichtungsfläche durch Aufgießen oder Aufspritzen unter Ausbildung einer Schlickerschicht mit einer Schichtdicke von mindestens 0,3 mm, und
(III) Trocknen der Schlickerschicht, indem die Dispersionsflüssigkeit mit einer Rate und in einer Richtung abgezogen wird, derart, dass unter Wirkung der abziehenden Dispersionsflüssigkeit die Feinfraktion im Außenbereich der Körnungsschicht angereichert wird und dabei eine Gießhaut bildet.

2. Verfahren nach Anspruch 1, **dadurch gekennzeichnet, dass** eine Maßnahme vorgesehen ist, die bewirkt, dass die Schlickerschicht langsamer trocknet als ohne die Maßnahme, wobei
die Maßnahme das Befeuchten der Beschichtungsfläche vor dem Aufbringen der Dispersion gemäß Verfahrensschritt (II) umfasst.

3. Verfahren nach einem der vorhergehenden Ansprüche, **dadurch gekennzeichnet, dass** die Schlickerschicht mechanisch verdichtet wird.

4. Verfahren nach Anspruch 3, **dadurch gekennzeichnet, dass** das Verdichten eine Behandlung der Schlickerschicht durch Rakeln umfasst.

5. Verfahren nach einem der vorhergehenden Verfahrensansprüche, **dadurch gekennzeichnet, dass** die Schlickerschicht mit einer Schichtstärke von maximal 3 mm, vorzugsweise maximal 1,5 mm erzeugt wird.

6. Verfahren nach einem der vorhergehenden Ansprüche, **dadurch gekennzeichnet, dass** die Dispersion bezogen auf ihren gesamten Feststoffgehalt einen Gewichtsanteil an SiO₂-Nanoteilchen bis maximal 10 % enthält.

7. Verfahren nach einem der vorhergehenden Ansprüche, **dadurch gekennzeichnet, dass** die Grobfraktion splittrige, amorphe SiO₂-Körnung mit einer Korngrößenverteilung mit einem D₅₀-Wert im Bereich zwischen 3 µm und 30 µm ist.

8. Verfahren nach einem der vorhergehenden Ansprüche, **dadurch gekennzeichnet, dass** die Dispersionsflüssigkeit auf wässriger Basis besteht.

9. Verfahren nach einem der vorhergehenden Ansprüche, **dadurch gekennzeichnet, dass** der Feststoffgehalt der Dispersion im Bereich zwischen 70 bis 80 Gew.-%, vorzugsweise zwischen 74 und 78 Gew.-% liegt.

10. Verfahren nach einem der vorhergehenden Ansprüche, **dadurch gekennzeichnet, dass** eine Dispersion eingesetzt wird, die frei von Bindemitteln ist.

11. Verfahren nach einem der vorhergehenden Ansprüche, **dadurch gekennzeichnet, dass** die Gießhaut eine Dicke im Bereich von 3 bis 15 µm, besonders bevorzugt im Bereich von 5 bis 10 µm aufweist.

12. Verfahren nach einem der vorhergehenden Ansprüche, **dadurch gekennzeichnet, dass** die Feinfraktion aus SiO₂-Nanoteilchen mit Teilchengrößen von weniger als 100 nm einen Volumenanteil der Gießhaut von mehr als 70 %, bevorzugt einen Volumenanteil von mehr als 80 % ausmachen.

## Claims

1. A method for producing a coated component consisting of transparent or opaque fused silica, the method comprising the following steps:
(a) providing a substrate of transparent or of opaque fused silica that comprises a coating surface;
(b) applying a SiO₂ granulation layer to the coating surface, said granulation layer having an inner portion adjoining the coating surface and having a first granulation fine fraction, and an outer portion adjoining the free surface of the granulation layer and having a second granulation fine fraction, wherein the second granulation fine fraction is higher than the first granulation fine fraction;
(c) sintering the granulation layer so as to form a dense SiO₂ surface layer, **characterized in that** the supplying the SiO₂ granulation layer according to method step (b) comprises:
(I) providing a dispersion containing a dispersion liquid that comprises amorphous SiO₂ particles which form a coarse fraction with particle sizes ranging between 1 µm and 50 µm and a fine fraction of SiO₂ nanoparticles having particle sizes of less than 100 nm, wherein the solids content constitutes between 70 and 80 wt.-% of the dispersion, and wherein the SiO₂ nanoparticles constitute between 2 wt.-% and 15 wt.-% of the dispersion,
(II) applying the dispersion to the coating surface by casting or spraying it thereonto so as to form a slurry layer having a layer thickness of at least 0.3 mm; and
(III) drying the slurry layer by removing the dispersion liquid at a rate and in a direction such that the removing of the dispersion liquid enriches the fine fraction in the outer portion of the granulation layer, thereby a casting skin is formed.

2. The method according to claim 1, **characterized in that** a measure is provided that slows the drying rate of the slurry layer wherein said measure comprises moisturizing the coating surface prior to applying of the dispersion according to method step (II).

3. The method according to any one of the preceding claims, **characterized in that** that the slurry layer is mechanically densified.

4. The method according to claim 3, **characterized in that** densification comprises a treatment of the slurry layer by spreading with a doctor blade.

5. The method according to any one of the preceding claims, **characterized in that** the layer thickness of the slurry layer not more than 3 mm, preferably not more than 1.5 mm.

6. The method according to any one of the preceding claims, **characterized in that** the SiO₂ nanoparticles in the dispersion constitutes not more than 10% by weight of the dispersion.

7. The method according to any one of the preceding claims, **characterized in that** the coarse fraction consists of splintery amorphous SiO₂ granules with a grain size distribution having a D₅₀ value in the range between 3 µm and 30 µm.

8. The method according to any one of the preceding claims, **characterized in that** the dispersion liquid consists of an aqueous base.

9. The method according to any one of the preceding claims, **characterized in that** the solids content of the dispersion is in the range between 70-80 wt.-%, preferably between 74 wt.-% and 78 wt.-%

10. The method according to any one of the preceding claims, **characterized in that** a dispersion is used that is free of binders.

11. The method according to any one of the preceding claims, **characterized in that** the casting skin has a thickness ranging from 3 µm to 15 µm, particularly preferably ranging from 5 µm to 10 µm.

12. The method according to any one of the preceding claims, **characterized in that** the fine fraction of SiO₂ nanoparticles with particle sizes of less than 100 nm constitute a volume fraction of the casting skin of more than 70%, preferably a volume fraction of more than 80%.

## Revendications

1. Procédé pour la fabrication d'un composant revêtu de verre de quartz ou de silice fondue, comprenant les étapes suivantes :
(a) préparation d'un substrat en verre de quartz ou en silice fondue préparant une surface de revêtement,
(b) application d'une couche de grains en SiO₂ sur la surface de revêtement qui présente une première fraction de grains sur la zone interne adjacente à la surface de revêtement et une seconde fraction de grains sur la zone externe adjacente à la surface de revêtement, la seconde fraction fine de grains étant plus élevée que la première fraction fine de grains,
(c) frittage de la couche de grains pour former une couche de surface dense de SiO₂,
**caractérisé en ce que** l'application de la couche de grains de SiO₂ selon l'étape de procédé (b) comprend :
(i) la fourniture d'une dispersion comprenant un liquide de dispersion et de particules amorphes de SiO₂ qui forme une fraction grossière des particules avec des tailles de particules comprises entre 1 µm et 50 µm et une fraction fine de nanoparticules SiO₂ avec des particules de taille inférieure à 100 nm, la teneur en matières solides du poids de la dispersion étant inférieure à 80 % en poids et dont 2 à 15% en poids sont des nanoparticules de SiO₂,
(II) application de la dispersion sur la surface de revêtement par coulée ou pulvérisation en formant une couche de barbotine d'une épaisseur d'au moins 0,3 mm, et
(III) séchage de la couche de barbotine, le liquide de dispersion étant extrait à un débit et dans une direction, de telle sorte que sous l'action d'extraction de la solution de dispersion, la fraction fine est accumulée dans la zone externe de la couche de grains et forme ainsi une peau de coulée.

2. Procédé selon la revendication 1, **caractérisé en ce qu'**une mesure est prévue, pour ralentir le séchage de la couche de barbotine que cela ne le serait sans cette mesure, cette mesure comprenant le mouillage de la surface de revêtement avant l'application de la dispersion selon l'étape de procédé (II).

3. Procédé selon l'une des revendications précédentes, **caractérisé en ce que** la couche de barbotine est compactée mécaniquement.

4. Procédé selon la revendication 3, **caractérisé en ce que** le compactage comprend un traitement de la couche de barbotine par raclage.

5. Procédé selon l'une des revendications de procédé précédentes, **caractérisé en ce que** la couche de barbotine est réalisée avec une épaisseur de maximum 3 mm, de préférence au maximum 1,5 mm.

6. Procédé selon l'une des revendications précédentes, **caractérisé en ce que** la dispersion, par rapport à sa teneur totale en matières solides, contient une teneur en poids de SiO₂ jusqu'à maximal 10% de nanoparticules de SiO₂.

7. Procédé selon l'une des revendications précédentes, **caractérisé en ce que** la fraction grossière amorphe de granulés de SiO₂ fendus ayant une répartition granulométrique avec une valeur D₅₀ est comprise entre 3 µm et 30 µm

8. Procédé selon l'une des revendications précédentes, **caractérisé en ce que** le liquide de dispersion est de base aqueuse.

9. Procédé selon l'une des revendications précédentes, **caractérisé en ce que** la teneur en matières solides de la dispersion est comprise entre 70 et 80% en poids, de préférence entre 74 et 78% en poids.

10. Procédé selon l'une des revendications précédentes, **caractérisé en ce qu'**on utilise une dispersion qui est exempte de liants.

11. Procédé selon l'une des revendications précédentes, **caractérisé en ce que** la peau de coulée a une épaisseur comprise entre 3 et 15 µm, de préférence particulièrement entre 5 et 10 µm.

12. Procédé selon l'une des revendications précédentes, **caractérisé en ce que** la fraction fine de nanoparticules de SiO₂ avec des tailles de particules inférieures à 100 nm représentent une fraction volumique de la peau de coulée de plus de 70%, de préférence une fraction volumique de plus de 80%.
